# EUROPÄISCHE PATENTSCHRIFT

(11) **EP 2 090 906 B1**
(45) Veröffentlichungstag und Bekanntmachung des Hinweises auf die Patenterteilung: **23.05.2018**
(21) Anmeldenummer: 09000637.0
(22) Anmeldetag: 17.01.2009
(51) Int. Cl.: G01V 8/20, H05K 1/14

(54) **Optischer sensor**
Optical sensor
Capteur optique

(30) Priorität: 15.02.2008 DE 202008002116 U
(43) Veröffentlichungstag der Anmeldung: 19.08.2009
(73) Patentinhaber: Leuze electronic GmbH + Co. KG, 73277 Owen/Teck (DE)
(72) Erfinder: Eisenlauer, Stefan, 82256 Fürstenfeldbruck (DE); Tkach, Gennadiy, 81373 München (DE)
(74) Vertreter: Ruckh, Rainer Gerhard

(56) Entgegenhaltungen:
- JP-A- H0 785 910
- US-A1- 2003 103 347
- US-A1- 2003 223 235
- US-A1- 2004 159 778
- US-A1- 2005 007 033

## Beschreibung

Die Erfindung betrifft einen optischen Sensor.

Optische Sensoren der in Rede stehenden Art können insbesondere als Lichtgitter ausgebildet sein. Ein derartiges Lichtgitter weist eine Reihenanordnung von Lichtstrahlen emittierenden Sendern auf, die in einem ersten Gehäuse untergebracht sind. Weiterhin weist das Lichtgitter eine Reihenanordnung von Lichtstrahlen empfangenden Empfängern auf, die in einem zweiten Gehäuse untergebracht sind. Jeweils ein Sender ist einem Empfänger zugeordnet und bildet mit diesem eine Strahlachse. Bei freiem Überwachungsbereich treffen die Lichtstrahlen aller Sender auf die zugeordneten Empfänger. Bei Eindringen eines Objekts in den Überwachungsbereich werden die Lichtstrahlen wenigstens einer Strahlachse unterbrochen, wodurch im Lichtgitter eine Objektmeldung generiert wird.

Je nach Applikation ist es notwendig, das Lichtgitter mit einer unterschiedlichen Anzahl von Strahlachsen auszustatten. Zur applikationsspezifischen Ausgestaltung werden die Gehäuse der Lichtgitter, die vorzugsweise aus Stranggussprofilen bestehen, in der benötigten Länge zugeschnitten, um dann die benötigte Anzahl an Sendern beziehungsweise Empfängern in dem jeweiligen Gehäuse unterzubringen. Die Sender- und Empfängeranordnungen sind so vorkonfektioniert, dass eine bestimmte Anzahl von Sendern oder Empfängern in einer linearen Anordnung auf einer Leiterplatte platziert sind. Wird in einem Lichtgitter eine größere Anzahl von Sendern und Empfängern benötigt, so werden in das erste Gehäuse mehrere Leiterplatten mit Sendern in deren Längsrichtung hintereinander im Gehäuse eingebaut. Dasselbe gilt für die Empfängeranordnung im zweiten Gehäuse.

Nachteilig hierbei ist der hohe konstruktive Aufwand, der bei der Integration der Leiterplatten in einem solchen Gehäuse notwendig ist.

Zunächst müssen die Leiterplatten in dem Gehäuse eingebaut und dabei relativ zueinander so lagefixiert werden, dass die Längsachsen der Leiterplatten exakt entlang einer Geraden verlaufen. Dann müssen die Leiterplatten miteinander elektrisch verbunden werden. Hierzu werden geeignete Stecker und Buchsen verwendet. Abgesehen davon, dass derartige Anschlussmittel selbst bereits sehr kostenintensiv sind, müssen derartige Anschlussmittel durch Lötarbeiten und Einsatz zusätzlicher Verbindungsteile wie Flachbandkabel an den Leiterplatten angeschlossen werden, was einen erheblichen Montageaufwand mit sich bringt.

Die US 2004/0159778 A1 betrifft einen mehrachsigen photoelektrischen Sensor. Sensorkomponenten des Sensors sind auf mehreren Leiterplatten angeordnet. Zwei Leiterplatten werden dadurch verbunden und mechanisch fixiert, dass Stifte einer ersten Leiterplatte in Löcher einer zweiten Leiterplatte eingesteckt werden. Da die Stifte und die Ränder der Löcher aus metallischen Werkstoffen bestehen, wird dadurch auch eine leitende Verbindung zwischen den Leiterplatten erhalten.

Die US 2005/0007033 A1 betrifft ein Leuchtgerät mit einer Anordnung von Leiterplatte zur Aufnahme von Leuchtmitteln. Die Leiterplatten werden über Befestigungselemente verbunden. In diesen Befestigungselementen können elektrisch leitende Elemente eingesetzt werden, um die Leiterplatten elektrisch zu verbinden.

Die US 2003/0103347 A1 betrifft ein modulares Beleuchtungssystem. Zur elektrischen und mechanischen Verbindung zweiter Leiterplatten sind flexible elektrisch leitende Kontaktelemente vorgesehen.

Die US 2003/0223235 A1 betrifft eine Beleuchtungseinheit. Zur elektrischen Verbindung zweier Beleuchtungselemente tragender Leiterplatten sind kabelförmige Verbindungen vorgesehen.

In JP H07 85 910 A ist ein Verbinder zur Verbindung zweier Leiterplatten beschrieben. Der Verbinder weist einen kopfförmigen Grundkörper auf, an dessen Unterseite Rastelemente zur mechanischen Verbindung der Leiterplatten vorgesehen sind. An zwei gegenüberliegenden Seiten des Grundkörpers münden nach unten gebogene, armförmige elektrische Kontakte aus, die mit elektrischen Kontaktstellen an den Leiterplatten in Verbindung gebracht werden.

Der Erfindung liegt die Aufgabe zugrunde, den Montageaufwand für einen optischen Sensor der eingangs genannten Art zu reduzieren.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Der erfindungsgemäße optische Sensor dient zur Erfassung von Objekten in einem Überwachungsbereich und umfasst zwei Leiterplatten, auf welchen Sensorkomponenten angeordnet sind. Die beiden Leiterplatten sind durch ein Verbindungselement in Sollpositionen zueinander lagefixiert, wobei das Verbindungselement Kontaktelemente aufweist, die bei Herstellung der mechanischen Verbindung der Leiterplatten durch das Verbindungselement mit Kontaktflächen der Leiterplatten eine elektrisch leitende Verbindung bilden. Durch eine mechanische Lagefixierung der Leiterplatten ist mit dem Verbindungselement gewährleistet, dass die Kontaktelemente des Verbindungselements exakt in ihren Sollpositionen an den Kontaktflächen der Leiterplatten liegen. Eine mechanische Lagefixierung der Leiterplatten ist mit dem Verbindungselement gewährleistet. Die Kontaktelemente des Verbindungselements liegen exakt in ihren Sollpositionen an den Kontaktflächen der Leiterplatten. Das Verbindungselement und die Leiterplatten bilden eine Rastverbindung. Das Verbindungselement weist eine Trägerplatte, in welcher die Kontaktelemente gelagert sind, sowie Raststifte zur Ausbildung der Rastverbindung mit den Leiterplatten auf. Die Raststifte sind aufbiegbar. Jede Leiterplatte weist ein Paar von Aussparungen auf. Jeweils ein Raststift ist in einer Aussparung eines Paares der jeweiligen Leiterplatte einrastbar. Die ein Paar bildenden Aussparungen münden an gegenüberliegenden seitlichen Rändern aus, so dass die Raststifte seitlich in die Aussparungen einrastbar sind.

Ein wesentlicher Vorteil der Erfindung besteht darin, dass durch die Lagefixierung der Leiterplatten mittels der Verbindungselemente durch die in diesem integrierten Kontaktelemente gleichzeitig eine elektrische Verbindung zwischen den beiden Leiterplatten herstellt. Separate Bauteile wie Stecker, Buchsen, Flachbandkabel oder dergleichen werden hierzu nicht mehr benötigt. Auch müssen keine Lötarbeiten durchgeführt werden, um die Leiterplatten elektrisch miteinander zu verbinden. Der Montageaufwand zur mechanischen und elektrischen Verbindung beider Leiterplatten kann somit sehr gering gehalten werden.

Durch die mechanische Lagefixierung der Leiterplatten mit dem Verbindungselement ist gewährleistet, dass die Kontaktelemente des Verbindungselements exakt in ihren Sollpositionen an den Kontaktflächen der Leiterplatten liegen, so dass eine sichere und reproduzierbare elektrische Verbindung zwischen den Leiterplatten hergestellt wird.

Besonders vorteilhaft sind die Kontaktelemente federnd im Verbindungselement gelagert oder selbst federnd oder elastisch verformbar ausgebildet, so dass bei Anbringen des Verbindungselements an die Leiterplatten die Kontaktelemente mit einem Anpressdruck an den Kontaktflächen der Leiterplatten anliegen. Dadurch wird eine besonders prozesssichere elektrische Verbindung der Kontaktelemente und der Kontaktflächen realisiert, die unempfindlich gegen äußere Störeinflüsse wie Vibrationen und Erschütterungen ist. Weiterhin ist vorteilhaft, dass die federnden elastischen, mit Anpresskräften gegen die Kontaktflächen gedrückten Kontaktelemente gegebenenfalls vorhandene Toleranzen kompensieren können, das heißt die Kontaktelemente selbst brauchen nicht toleranzarm oder toleranzfrei hergestellt werden, was zu geringen Herstellkosten des Verbindungselements führt.

Das Verbindungselement selbst ist vorteilhaft einstückig ausgebildet und besteht besonders vorteilhaft aus einem Spritzgussteil aus elektrisch isolierendem Kunststoff. Das Verbindungselement kann somit rationell und kostengünstig hergestellt werden.

Das Verbindungselement ist als auf die Leiterplatte aufsteckbares und aufrastbares Teil ausgebildet. Die Verbindung der Leiterplatte mittels des Verbindungselements kann somit besonders einfach und schnell hergestellt werden. Weiterhin sorgt die Rastverbindung für einen guten Halt des Verbindungselements an den Leiterplatten.

Als Rastelemente weist das Verbindungselement besonders vorteilhaft zwei Paare von Raststiften auf, die an einer Trägerplatte, welche einen weiteren Bestandteil des Verbindungselements bildet und welche die Kontaktelemente aufnimmt, angeordnet sind. Die biegsamen Raststifte können an seitlich an den Leiterplatten ausmündenden Aussparungen aufgerastet werden. Die so ausgebildeten Aussparungen bilden Rastaufnahmen, die an den Leiterplatten platzsparend vorgesehen werden können. Weiterhin ist vorteilhaft, dass die seitlich in die Aussparungen eingreifenden Raststifte Rastelemente bilden, die eine sichere, gegen Toleranzen der einzelnen Bauelemente unempfindliche Verbindung mit den Leiterplatten bilden.

Die Erfindung wird im Folgenden anhand der Zeichnungen erläutert. Es zeigen:
- Figur 1:: Schematische Darstellung eines Lichtgitters.
- Figur 2:: Detaildarstellung zweier aneinandergrenzender Leiterplatten mit einem Verbindungselement zur Verbindung der Leiterplatte für das Lichtgitter gemäß Figur 1.
- Figur 3:: Schnittdarstellung des Verbindungselements gemäß Figur 2.

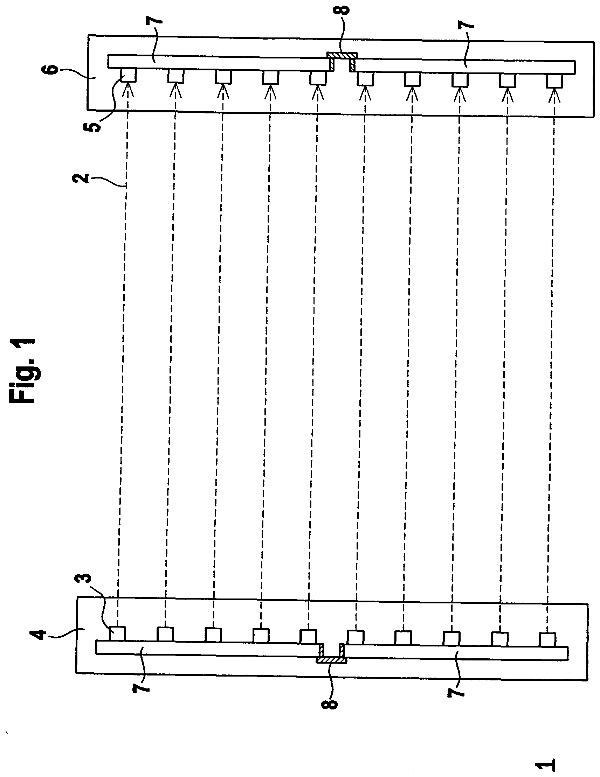

Figur 1 zeigt als Ausführungsbeispiel eines optischen Sensors ein Lichtgitter 1 zur Erfassung von Objekten in einem Überwachungsbereich. Das Lichtgitter 1 weist eine Anordnung von Lichtstrahlen 2 emittierenden Sendern 3 auf, die längs einer Geraden hintereinander angeordnet in einem ersten Gehäuse 4 untergebracht sind. Die Sender 3 werden von einer nicht dargestellten Steuereinheit innerhalb des ersten Gehäuses 4 angesteuert und sind von Leuchtdioden oder dergleichen gebildet. Den Sendern 3 kann jeweils eine nicht dargestellte Sendeoptik vorgeordnet sein. Das Lichtgitter 1 weist weiterhin eine Anordnung von Lichtstrahlen 2 empfangenden Empfängern 5 auf, die längs einer Geraden hintereinander angeordnet in einem zweiten Gehäuse 6 untergebracht sind. Zur Steuerung des Betriebs der Empfänger 5 und zur Auswertung der Empfangssignale der Empfänger 5 ist im zweiten Gehäuse 6 eine nicht dargestellte Auswerteeinheit vorgesehen. Die Auswerteeinheit weist, um einen Einsatz des Lichtgitters 1 im Bereich des Personenschutzes zu ermöglichen, einen redundanten Aufbau auf, beispielsweise in Form von zwei sich gegenseitig zyklisch überwachenden Rechnereinheiten. Den Empfängern 5, die insbesondere von Photodioden gebildet sind, kann jeweils eine nicht dargestellte Empfangsoptik vorgeordnet sein. In den dem Überwachungsbereich zugewandten Frontbreiten der Gehäuse 4, 6 ist jeweils ein nicht dargestelltes Fenster vorgesehen, durch welches die Lichtstrahlen 2 geführt sind.

Die Sender 3 im ersten Gehäuse 4 sind an einem Rand des Überwachungsbereichs den Empfängern 5 im zweiten Gehäuse 6 am gegenüberliegenden Rand des Überwachungsbereichs so zugeordnet, dass jeweils ein Sender 3 einem Empfänger 5 gegenüberliegt und mit diesem eine Strahlachse bildet. Bei freiem Überwachungsbereich treffen die Lichtstrahlen 2 des Senders 3 einer Strahlachse ungehindert auf den Empfänger 5 dieser Strahlachse. Bei einem Objekteingriff in den Überwachungsbereich wird wenigstens eine Strahlachse unterbrochen. Zur Objektdetektion werden die Empfangssignale der Empfänger 5 in der Auswerteeinheit mit wenigstens einem Schwellwert bewertet. Dadurch wird ein binäres Objektfeststellungssignal geniert, dessen Schaltzustände angeben, ob sich ein Objekt im Überwachungsbereich befindet oder nicht.

Wie aus Figur 1 ersichtlich, sind im ersten Gehäuse 4 zwei Leiterplatten 7 integriert, wobei auf jeder Leiterplatte 7 die Hälfte der Sender 3 platziert ist. Entsprechend sind im zweiten Gehäuse 6 zwei Leiterplatten 7 integriert, wobei auf jeder Leiterplatte 7 die Hälfte der Empfänger 5 platziert ist. Die Leiterplatten 7 sind in nicht gesondert dargestellten Halterungen oder Aufnahmen innerhalb der Gehäuse 4, 6 ortsfest gelagert. Jeweils eine Leiterplatte 7 mit einer Anzahl von Sendern 3 oder Empfängern 5 bildet eine Baueinheit. Je nach Applikation kann ein Lichtgitter 1 mit einer unterschiedlichen Anzahl von Sendern 3 und einer entsprechenden Anzahl von Empfängern 5 benötigt werden. Dementsprechend erfolgt eine Kaskadierung des Lichtgitters 1 derart, dass jeweils eine vorgegebene Anzahl von Leiterplatten 7 mit Sendern 3 und eine vorgegebene Anzahl von Leiterplatten 7 mit Empfängern 5 eingesetzt wird. Die Längen der Gehäuse 4, 6 werden dabei an die Anzahl der verwendeten Leiterplatten 7 angepasst. Vorzugsweise bestehen die Gehäuse 4, 6 aus Stranggussprofilen, die hierfür in der geeigneten Länge zugeschnitten werden können.

Wie aus Figur 1 ersichtlich, sind die Längsachsen der Leiterplatte 7 mit den Sendern 3 im ersten Gehäuse 4 längs einer Geraden ausgerichtet. Dabei sind die Leiterplatten 7 mit aneinander angrenzenden längsseitigen Enden durch ein Verbindungselement 8 verbunden. Die Anordnung der Leiterplatten 7 mit den Empfängern 5 im zweiten Gehäuse 6 ist entsprechend ausgebildet.

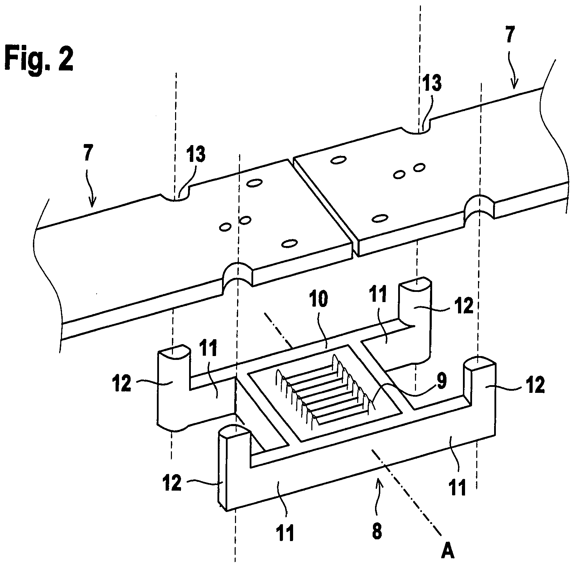

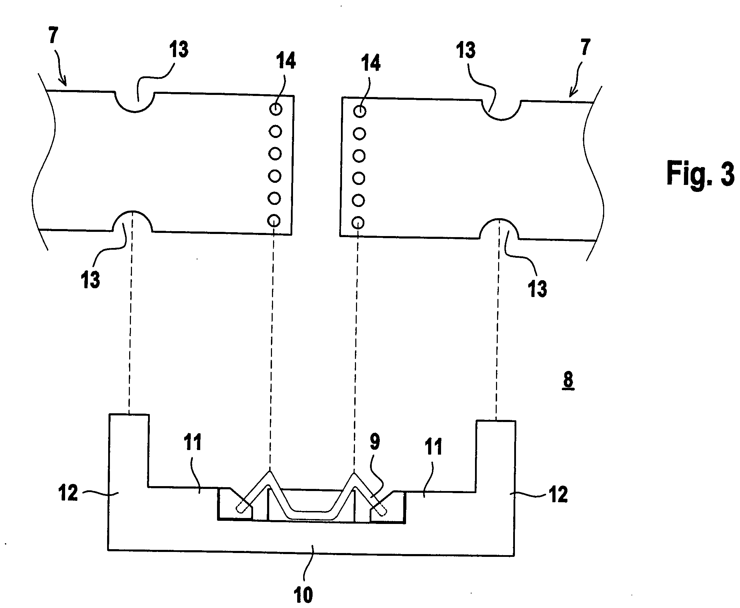

Figur 2 zeigt die aneinander angrenzenden Enden zweier Leiterplatten 7 sowie das Verbindungselement 8 zur Verbindung dieser Leiterplatten 7. Weiterhin zeigt Figur 3 eine Schnittdarstellung des Verbindungselements 8 sowie eine Draufsicht auf die Unterseiten der Leiterplatten 7. Das Verbindungselement 8 besteht aus einem einstückig ausgebildeten Kunststoff-Spritzgussteil aus isolierendem, das heißt nicht leitfähigem Kunststoff sowie aus darin gelagerten elektrisch leitfähigen Kontaktelementen 9. Die Kontaktelemente 9 bestehen bevorzugt aus metallischen Werkstoffen, wobei die Kontaktelemente 9 besonders vorteilhaft mit einer Goldschicht beschichtet werden, so dass diese korrosionsunempfindlich sind.

Das Verbindungselement 8 weist eine Trägerplatte 10 mit rechteckigem Querschnitt auf, in welcher die Kontaktelemente 9 gelagert sind. An gegenüber liegenden Seiten der Trägerplatte 10 mündet jeweils an einem Rand der Trägerplatte 10 ein Arm 11 aus. Die vier Arme 11 sind einstückig mit der Trägerplatte 10 ausgebildet und verlaufen in der Ebene der Trägerplatte 10 jeweils parallel zueinander. An jedem freien Ende eines Arms 11 ist ein Raststift 12 vorgesehen. Jeder Raststift 12 steht über die Oberseiten der Arme 11 und der Trägerplatte 10 hervor, wobei die Längsachsen der Raststifte 12 senkrecht zu den Längsachsen der Arme 11 orientiert sind.

Die Arme 11 einerseits und die Raststifte 12 andererseits sind jeweils identisch ausgebildet. Dabei bilden die über die gegenüberliegenden Seiten der Trägerplatte 10 hervorstehenden Paare von Raststiften 12 eine zur Symmetrieachse A des Verbindungselements 8 spiegelsymmetrische Anordnung.

Jeder Raststift 12 weist einen halbkreisförmigen, konstanten Querschnitt auf, wobei die ineinander zugewandten Seiten der Raststifte 12 eines Paares konvex ausgewölbt sind, während die einander abgewandten Seiten der Raststifte 12 ebene Flächen bilden. Die Querschnitte der Raststifte 12 sind so dimensioniert, dass die Raststifte 12 etwas aufgebogen werden können.

Die Raststifte 12 bilden Rastelemente, mittels derer das Verbindungselement 8 auf die beiden Leiterplatten 7 aufgerastet werden kann. Als Aufnahmen für die Raststifte 12 ist an beiden Leiterplatten 7 im Bereich der längsseitigen Enden jeweils ein Paar von Aussparungen 13 vorgesehen, die jeweils die Leiterplatte 7 axial durchsetzen und die an einem seitlichen Rand der Leiterplatten 7 ausmünden. Wie aus den Figuren 2 und 3 ersichtlich, ist an jeder Leiterplatte 7 ein Paar von Aussparungen 13 vorgesehen, wobei die beiden Aussparungen 13 gegenüberliegend angeordnet sind. Die Aussparungen 13 aller Leiterplatten 7 sind identisch ausgebildet und weisen einen halbkreisförmigen Querschnitt auf, der an die Konturen der Raststifte 12 angepasst ist.

Die in der Trägerplatte 10 gelagerten Kontaktelemente 9 sind als federnde Elemente, im vorliegenden Fall als Federkontakte ausgebildet. Wie aus Figur 3 ersichtlich, weist jedes Kontaktelement 9 ein zentrales, längs einer Geraden und im Bodenbereich der Trägerplatte 10 verlaufendes Segment auf, an dessen längsseitige Enden jeweils ein nach oben gebogenes, über die Oberseite der Trägerplatte 10 hervorstehendes Segment anschließt. Die so ausgebildeten Kontaktelemente 9 sind symmetrisch zur Symmetrieachse ausgebildet.

Alternativ zu Federkontakten können als Kontaktelemente 9 auch elastisch verformbare Elemente oder starre Elemente, die federnd gelagert sind, eingesetzt werden.

Die Kontaktelemente 9 des Verbindungselements 8 können mit Kontaktflächen 14 an den Unterseiten der Leiterplatten 7 kontaktiert werden. Die Kontaktflächen 14 sind in Figur 3 dargestellt. Die Anzahlen und die Größen der Kontaktflächen 14 an den Leiterplatten 7 sind an die Anzahlen und Größen der Kontaktelemente 9 des Verbindungselements 8 angepasst.

Zur Verbindung zweier Leiterplatten 7 und seiner gleichzeitigen Kontaktierung der Leiterplatten 7 wird das Verbindungselement 8 auf die längsseitigen Enden der Leiterplatten 7 von unten aufgesteckt. Bei Aufstecken des Verbindungselements 8 liegen die längsseitigen Enden der Leiterplatten 7, wie in Figur 2 dargestellt, dicht aneinander. Das Verbindungselement 8 wird so auf die Leiterplatten 7 aufgesteckt, dass die Symmetrieachse A des Verbindungselements 8 entlang der Trennlinie zwischen den beiden Leiterplatten 7 verläuft. Die Raststifte 12 auf einer Seite der Trägerplatte 10 werden bei Aufstecken der Leiterplatten 7 seitlich in die Aussparung 13 der ersten Leiterplatte 7 eingeführt, während die Raststifte 12 auf der anderen Seite der Trägerplatte 10 in die Aussparung 13 der zweiten Leiterplatte 7 seitlich eingeführt werden. Bei dem seitlichen Einführen der Raststifte 12 in die Aussparung 13 liegen die Raststifte 12 etwas auf. Nach dem Aufrasten der Raststifte 12 federn diese zurück und liegen dicht in den Ausnehmungen, wobei durch die Vorspannung der biegsamen Raststifte 12 ein sicherer Halt der Raststifte 12 in den Aussparungen 13 und damit des Verbindungselements 8 an den Leiterplatten 7 gewährleistet ist.

Bei auf die Leiterplatten 7 aufgestecktem Verbindungselement 8 liegt die Oberseite der Trägerplatte 10 dicht unterhalb der Unterseiten der Leiterplatten 7, so dass die über die Oberseiten der Trägerplatte 10 herausstehenden Segmente gegen die Kontaktflächen 14 beider Leiterplatten 7 gedrückt werden. Da die Kontaktelemente 9 als Federkontakte ausgebildet sind, üben die Kontaktelemente 9 Federkräfte in Richtung der Kontaktfläche 14 aus, so dass die Kontaktelemente 9 mit Anpresskräften an den Kontaktflächen 14 anliegen. Diese Kontaktierung ist durch die wirkenden Federkräfte der Kontaktelemente 9 unempfindlich gegen äußere Störeinflüsse wie Vibrationen und Erschütterungen. Weiterhin ist diese elektrische Kontaktierung der Leiterplatten 7 unempfindlich gegen Toleranzen der verwendeten Bauteile. Mit dem Verbindungselement 8 wird eine sichere elektrische Verbindung zwischen den Leiterplatten 7 geschaffen, ohne dass hierfür Lötarbeiten oder Zuatzelemente wie Stecker oder Buchsen benötigt werden.

### Bezugszeichenliste

- (1): Lichtgitter
- (2): Lichtstrahlen
- (3): Sender
- (4): Gehäuse
- (5): Empfänger
- (6): Gehäuse
- (7): Leiterplatte
- (8): Verbindungselement
- (9): Kontaktelement
- (10): Trägerplatte
- (11): Arm
- (12): Raststift
- (13): Aussparung
- (14): Kontaktfläche

## Patentansprüche

1. Optischer Sensor zur Erfassung von Objekten in einem Überwachungsbereich, umfassend wenigstens zwei Leiterplatten, auf welchen Sensorkomponenten angeordnet sind, wobei die beiden Leiterplatten (7) durch ein Verbindungselement (8) in Sollpositionen zueinander lagefixiert sind, wobei das Verbindungselement (8) Kontaktelemente (9) aufweist, die bei Herstellung der mechanischen Verbindung der Leiterplatten (7) durch das Verbindungselement (8) mit Kontaktflächen (14) der Leiterplatten (7) eine elektrisch leitende Verbindung bilden, wobei durch eine mechanische Lagefixierung der Leiterplatten (7) mit dem Verbindungselement (8) gewährleistet ist, dass die Kontaktelemente des Verbindungselements (8) exakt in ihren Sollpositionen an den Kontaktflächen (14) der Leiterplatten (7) liegen, **dadurch gekennzeichnet, dass** das Verbindungselement (8) und die Leiterplatten (7) eine Rastverbindung bilden, dass das Verbindungselement (8) eine Trägerplatte (10), in welcher die Kontaktelemente (9) gelagert sind, sowie Raststifte (12) zur Ausbildung der Rastverbindung mit den Leiterplatten (7) aufweist, wobei die Raststifte (12) aufbiegbar sind, dass jede Leiterplatte (7) ein Paar von Aussparungen (13) aufweist, wobei jeweils ein Raststift (12) in einer Aussparung (13) eines Paares der jeweiligen Leiterplatte (7) einrastbar ist, und die ein Paar bildenden Aussparungen (13) an gegenüberliegenden seitlichen Rändern der Leiterplatte (7) ausmünden, so dass die Raststifte (12) seitlich in die Aussparungen (13) einrastbar sind.

2. Optischer Sensor nach Anspruch 1, **dadurch gekennzeichnet, dass** das Verbindungselement (8) federnd gelagerte oder federnde oder elastisch verformbare Kontaktelemente (9) aufweist, welche insbesondere von aus elektrisch leitfähigem Material bestehenden Federkontakten gebildet sind.

3. Optischer Sensor nach einem der Ansprüche 1 oder 2, **dadurch gekennzeichnet, dass** bei Verbinden der Leiterplatten (7) mittels der Verbindungselemente (8) Segmente der Kontaktelemente (9) gegen die Kontaktflächen (14) der Leiterplatten (7) gedrückt sind.

4. Optischer Sensor nach einem der Ansprüche 1 bis 3, **dadurch gekennzeichnet, dass** das Verbindungselement (8) aus einem einstückigen Kunststoffteil besteht, in welchem die Kontaktelemente (9) gelagert sind.

5. Optischer Sensor nach einem der Ansprüche 1 bis 4, **dadurch gekennzeichnet, dass** die mit den Kontaktflächen der Leiterplatten (7) kontaktierbaren Segmente der Kontaktelemente (9) über die Oberseite der Trägerplatten (10) hervorstehen, dass an gegenüberliegenden Seiten der Trägerplatte (10) jeweils ein Paar von Raststiften (12) angeordnet ist, wobei ein erstes Paar der Raststifte (12) an der ersten Leiterplatte (7) und das zweite Paar der Raststifte (12) mit der zweiten Leiterplatte (7) verrastbar ist, und dass die Raststifte (12) jeweils über die Oberseite der Trägerplatte (10) hervorstehen.

6. Optischer Sensor nach einem der Ansprüche 1 bis 5, **dadurch gekennzeichnet, dass** das Verbindungselement (8) mehrere identische Arme (11) aufweist, die in der Ebene der Trägerplatte verlaufen und seitlich an dieser ausmünden, und dass jeder Raststift (12) an einem der seitlich ausmündenden Arme (11) angeordnet ist.

7. Optischer Sensor nach Anspruch 6, **dadurch gekennzeichnet, dass** die Längsachsen der Raststifte (12) senkrecht zur Ebene der Trägerplatte (10) orientiert sind.

8. Optischer Sensor nach einem der Ansprüche 1 bis 7, **dadurch gekennzeichnet, dass** die Konturen der Aussparungen (13) an die Konturen der Raststifte (12) angepasst sind.

9. Optischer Sensor nach einem der Ansprüche 1 bis 8, **dadurch gekennzeichnet, dass** dieser ein Lichtgitter (1) ist, welches zwei Gehäuse aufweist, dass in einem ersten Gehäuse (4) eine Reihenanordnung von Lichtstrahlen (2) emittierenden Sendern (3) vorgesehen ist, welche auf einer Anordnung von Leiterplatten (7) platziert sind, wobei jeweils benachbarte Leiterplatten (7) mit einem Verbindungselement (8) mechanisch verbunden und mit den auf dem Verbindungselement (8) vorgesehenen Kontaktelementen (9) elektrisch kontaktiert sind, und dass in einem zweiten Gehäuse (6) eine Reihenanordnung von Lichtstrahlen (2) empfangenden Empfängern (5) vorgesehen ist, welche auf einer Anordnung von Leiterplatten (7) platziert sind, wobei jeweils benachbarte Leiterplatten (7) mit einem Verbindungselement (8) mechanisch verbunden und mit den auf dem Verbindungselement (8) vorgesehenen Kontaktelementen (9) elektrisch kontaktiert sind.

## Claims

1. Optical sensor for detecting objects in a monitoring region, comprising at least two circuitboards on which sensor components are arranged, wherein the two circuitboards (7) are positionally fixed relative to one another in desired positions by a connecting element (8), wherein the connecting element (8) comprises contact elements (9) which form an electrically conductive connection when the mechanical connection of the circuitboards (7) by the connecting element (8) with the contact surfaces (14) of the circuitboards (7) is produced, and wherein through a mechanical positional fixing of the circuitboards (7) by the connecting element (8) it is ensured that the contact elements of the connecting element (8) lie exactly in the desired positions thereof at the contact surfaces (14) of the circuitboards (7), **characterised in that** the connecting element (8) and the circuitboards (7) form a detent connection, that the connecting element (8) comprises a support plate (10), in which the contact elements (9) are mounted, and detent pins (12) for forming the detent connection with the circuitboards (7), wherein the detent pins (12) are bendable, that each circuitboard (7) has a pair of cut-outs (13), wherein a respective pin (12) is detentable in each cut-out (13) of a pair of cut-outs of the respective circuitboard (13), and the cut-outs (13) forming a pair communicate with opposite lateral edges of the circuitboard (7) so that the detent pins (12) are laterally detentable in the cut-outs (13).

2. Optical sensor according to claim 1, **characterised in that** the connecting element (8) is resiliently mounted or has resiliently or elastically deformable contact elements (9) which are formed by, in particular, spring contacts consisting of electrically conductive material.

3. Optical sensor according to one of claims 1 and 2, **characterised in that** segments of the contact elements (9) are pressed against the contact surfaces (14) of the circuitboards (7) when the circuitboards (7) are connected by means of the connecting elements (8).

4. Optical sensor according to any one of claims 1 to 3, **characterised in that** the connecting element (8) consists of an integral plastics material part in which the contact elements (9) are mounted.

5. Optical sensor according to any one of claims 1 to 4, **characterised in that** the segments, which are contactable with the contact surfaces of the circuitboards (7), of the contact elements (9) project beyond the upper side of the support plates (10), that a respective pair of detent pins (12) is arranged at opposite sides of the support plate (10), wherein a first pair of the detent pins (12) is detentable at the first circuitboard (7) and the second pair of the detent pins (12) is detentable with the second circuitboard (7), and that the detent pins (12) each project beyond the upper side of the support plate (10).

6. Optical sensor according to any one of claims 1 to 5, **characterised in that** the connecting element (8) comprises a plurality of identical arms (11) which extend in the plane of the support plate and communicate laterally therewith and that each detent pin (12) is arranged on one of the laterally communicating arms (11).

7. Optical sensor according to claim 6, **characterised in that** the longitudinal axes of the detent pins (12) are oriented perpendicularly to the plane of the support plate (10).

8. Optical sensor according to any one of claims 1 to 7, **characterised in that** the contours of the cut-outs (13) are adapted to the contours of the detent pins (12).

9. Optical sensor according to any one of claims 1 to 8, **characterised in that** this is a light grating (1), which comprises two housings, that a series arrangement of transmitters (3), which emit light beams (2) and which are placed on an arrangement of circuitboards (7), is provided in a first housing (4), wherein respectively adjacent circuitboards (7) are mechanically connected by a connecting element (8) and can be placed in electrical contact with the contact elements (9) provided on the connecting element (8), and that a series arrangement of receivers (5), which receive light beams (2) and which are placed on an arrangement of circuitboards (7), is provided in a second housing (6), wherein respectively adjacent circuitboards (7) are mechanically connected by a connecting element (8) and are placed in electrical contact with the contact elements (9) provided on the connecting element (8).

## Revendications

1. Capteur optique pour la détection d'objets dans une zone de surveillance, comprenant au moins deux cartes de circuits imprimés sur lesquelles sont disposés des composants capteurs, les deux cartes de circuits imprimés (7) étant fixées dans des positions de consigne l'une par rapport à l'autre par un élément de liaison (8), l'élément de liaison (8) présentant des éléments de contact (9) qui, lors de l'établissement de la liaison mécanique des cartes de circuits imprimés (7) par l'élément de liaison (8), forment une liaison électroconductrice avec des surfaces de contact (14) des cartes de circuits imprimés (7), une fixation en position mécanique des cartes de circuits imprimés (7) avec l'élément de liaison (8) garantissant que les éléments de contact de l'élément de liaison (8) se trouvent exactement dans leurs positions de consigne sur les surfaces de contact (14) des cartes de circuits imprimés (7),
**caractérisé en ce que** l'élément de liaison (8) et les cartes de circuits imprimés (7) forment une liaison par encliquetage, que l'élément de liaison (8) présente une plaque de support (10), dans laquelle les éléments de contact (9) sont montés, ainsi que des broches d'encliquetage (12) pour réaliser la liaison par encliquetage avec les cartes de circuits imprimés (7), les broches d'encliquetage (12) étant relevables, que chaque carte de circuits imprimés (7) présente une paire d'évidements (13), une broche d'encliquetage (12) pouvant chaque fois être encliquetée dans un évidement (13) d'une paire de la carte de circuits imprimés (7) respective, et les évidements (13) formant une paire débouchant à des bords latéraux opposés de la carte de circuits imprimés (7), de sorte que les broches d'encliquetage (12) sont encliquetables latéralement dans les évidements (13).

2. Capteur optique selon la revendication 1, **caractérisé en ce que** l'élément de liaison (8) est monté élastique ou présente des éléments de contact (9) élastiques ou déformables élastiquement qui sont en particulier formés de ressorts de contact en matériau électroconducteur.

3. Capteur optique selon l'une des revendications 1 ou 2, **caractérisé en ce que** lors de l'assemblage des cartes de circuits imprimés (7) au moyen des éléments de liaison (8), des segments des éléments de contact (9) sont appuyés contre les surfaces de contact (14) des cartes de circuits imprimés (7).

4. Capteur optique selon l'une des revendications 1 à 3, **caractérisé en ce que** l'élément de liaison (8) est constitué d'une pièce en matière plastique monobloc dans laquelle les éléments de contact (9) sont montés.

5. Capteur optique selon l'une des revendications 1 à 4, **caractérisé en ce que** les segments des éléments de contact (9) pouvant être mis en contact avec les surfaces de contact des cartes de circuits imprimés (7) font saillie de la face supérieure des plaques de support (10), qu'une paire de broches d'encliquetage (12) est chaque fois disposée sur des côtés opposés de la plaque de support (10), une première paire de broches d'encliquetage (12) étant encliquetable sur la première carte de circuits imprimés (7) et la deuxième paire de broches d'encliquetage (12) avec la deuxième carte de circuits imprimés (7) et que les broches d'encliquetage (12) font chaque fois saillie de la face supérieure de la plaque de support (10).

6. Capteur optique selon l'une des revendications 1 à 5, **caractérisé en ce que** l'élément de liaison (8) présente plusieurs bras (11) identiques qui s'étendent dans le plan de la plaque de support et débouchent latéralement sur celle-ci, et que chaque broche d'encliquetage (12) est disposée sur un des bras (11) débouchant latéralement.

7. Capteur optique selon la revendication 6, **caractérisé en ce que** les axes longitudinaux des broches d'encliquetage (12) sont orientés perpendiculairement au plan de la plaque de support (10).

8. Capteur optique selon l'une des revendications 1 à 7, **caractérisé en ce que** les contours des évidements (13) sont adaptés aux contours des broches d'encliquetage (12).

9. Capteur optique selon l'une des revendications 1 à 8, **caractérisé en ce que** celui-ci est une barrière lumineuse multifaisceaux (1) qui présente deux boîtiers, que dans un premier boîtier (4) est prévue une disposition en série d'émetteurs (3) émettant des faisceaux lumineux (2) qui sont placés sur un agencement de cartes de circuits imprimés (7), des cartes de circuits imprimés (7) adjacentes étant chaque fois reliées mécaniquement par un élément de liaison (8) et mises en contact électrique avec les éléments de contact (9) prévus sur l'élément de liaison (8), et que dans un deuxième boîtier (6) est prévue une disposition en série de récepteurs (5) recevant des faisceaux lumineux (2) qui sont placés sur un agencement de cartes de circuits imprimés (7), des cartes de circuits imprimés (7) adjacentes étant chaque fois reliées mécaniquement par un élément de liaison (8) et mises en contact électrique avec les éléments de contact (9) prévus sur l'élément de liaison (8).
